# EUROPEAN PATENT APPLICATION

(11) **EP 4 219 621 A1**
(43) Date of publication of application: **02.08.2023**
(21) Application number: 21877526.0
(22) Date of filing: 01.10.2021
(51) Int. Cl.: C08L 33/02, C08F 220/04, C08F 220/10, C08F 220/34, C08L 33/14, C08L 101/00, H01L 23/36, H05K 1/05

(54) **COMPOSITION, CURED BODY, AND METAL BASE SUBSTRATE**

(30) Priority: 06.10.2020 JP 2020169121
(71) Applicant: Denka Company Limited, Tokyo 103-8338 (JP)
(72) Inventor: GONDA Yuhei, Tokyo 103-8338 (JP); KUMAGAI Ryota, Tokyo 103-8338 (JP)
(74) Representative: Hoffmann Eitle
(86) International application number: PCT/JP2021/036483
(87) International publication number: WO 2022/075227

(57) **Abstract**

A composition containing: an inorganic filler; and a copolymer containing a (meth)acrylic monomer unit A having an anionic group, a (meth)acrylic monomer unit B having a cationic group, and a (meth)acrylic monomer unit C other than the (meth)acrylic monomer unit A and the (meth)acrylic monomer unit B, wherein a content of the copolymer is 0.01 to 10 parts by mass with respect to 100 parts by mass of the inorganic filler.

## Description

### Technical Field

The present disclosure relates to a composition, a cured product, and a metal-based substrate.

### Background Art

Inorganic fillers formed of boron nitride, aluminum nitride, aluminum oxide, silicon nitride, silicon oxide, or the like are used in various fields for the purpose of improving insulating properties, thermal conductivity, and the like. In such a case, the inorganic filler is generally used by being dispersed in a resin or the like.

As a more specific example, the inorganic filler may be used in a composition for forming an insulating layer in a metal-based substrate (metal-based circuit board). For example, Patent Document 1 discloses a composition for a circuit board containing a specific epoxy resin, a curing agent, and an inorganic filler as essential components for the following purposes: to provide a composition composed of a curable resin containing an inorganic filler having a low elastic modulus and excellent in adhesiveness, heat resistance and moisture resistance; and to provide a circuit board, especially a metal base circuit board excellent in adhesion between a metal plate and a conductive circuit as its utilization, excellent in stress relaxation property, causing no abnormality at the time of crack generation in solder or its vicinity even when receiving rapid heating / cooling, and excellent in heat resistance, moisture resistance and heat radiation property.

### Citation List

### Patent Document

[Patent Document 1] Japanese Patent Application Publication No. 2008-266535.

### Summary of Invention

### Technical Problem

The above-described metal-based substrate is required to ensure insulation reliability even when a voltage higher than that conventionally applied, and in particular, improvement of insulation reliability under a high-temperature or high-temperature/high-humidity environment is desired.

Therefore, an object of one aspect of the present invention is to obtain a metal-based substrate having excellent insulation reliability against a high voltage in a high-temperature or high-temperature/high-humidity environment.

### Solution to Problem

The present inventors have found that, in a composition for forming an insulating layer of a metal-based substrate, a metal-based substrate having excellent insulation reliability against high voltage in a high-temperature or high-temperature/high-humidity environment can be obtained by combining a copolymer having the specific structure in the specific amount with an inorganic filler.

That is, in some aspects, the present invention provides the following [1] to [12].
[1] A composition containing: an inorganic filler; and a copolymer containing a (meth)acrylic monomer unit A having an anionic group, a (meth)acrylic monomer unit B having a cationic group, and a (meth)acrylic monomer unit C other than the (meth)acrylic monomer unit A and the (meth)acrylic monomer unit B, wherein a content of the copolymer is 0.01 to 10 parts by mass with respect to 100 parts by mass of the inorganic filler.
[2] The composition according to [1], wherein the anionic group contains one or more selected from the group consisting of a carboxy group, a phosphoric acid group, and a phenolic hydroxy group.
[3] The composition according to [1] or [2], wherein the (meth)acrylic monomer unit A further has an electron withdrawing group bonded to the anionic group.
[4] The composition according to any one of [1] to [3], wherein the cationic group contains one or more selected from the group consisting of a primary amino group, a secondary amino group, a tertiary amino group, and a quaternary ammonium salt group.
[5] The composition according to any one of [1] to [4], wherein the (meth)acrylic monomer unit B further has an electron donating group bonded to the cationic group.
[6] The composition according to any one of [1] to [5], wherein the (meth)acrylic monomer unit C contains one or more selected from the group consisting of an oxyalkylene group, a siloxane group, a hydrocarbon group, and a phosphoric acid ester group.
[7] The composition according to any one of [1] to [6], further containing a resin.
[8] The composition according to [7], further containing a curing agent for curing the resin.
[9] A cured product of the composition according to [8].
[10] A metal-based substrate containing: a metal plate; the cured product according to [9] disposed on the metal plate; and a metal foil disposed on the cured product.

### Advantageous Effects of Invention

According to one aspect of the present invention, it is possible to obtain a metal-based substrate having excellent insulation reliability against a high voltage in a high-temperature or high-temperature/high-humidity environment.

### Brief Description of Drawings

FIG. 1 is a schematic cross-sectional view showing an embodiment of a metal-based substrate.
FIG. 2 is a schematic cross-sectional view showing another embodiment of the metal-based substrate.

### Description of Embodiments

Hereinafter, embodiments of the present invention will be described in detail, but the present invention is not limited thereto.

One embodiment of the present invention is a composition containing an inorganic filler and a copolymer.

The inorganic filler may be, for example, a known inorganic filler used for applications requiring insulation and thermal conductivity. The inorganic filler may contain, for example, one or more selected from the group consisting of aluminum oxide, silicon oxide, silicon nitride, boron nitride, aluminum nitride, and magnesium oxide. From the viewpoint of further improving insulation reliability under a high-humidity environment, the inorganic filler may contain one or more selected from the group consisting of aluminum oxide, silicon oxide, silicon nitride, boron nitride, and aluminum nitride.

The shape of the inorganic filler may be, for example, a particle shape, a scale shape, or a polygonal shape. The average particle diameter of the inorganic filler may be 0.05 µm or more, 0.1 µm or more, 5 µm or more, 10 µm or more, 20 µm or more, or 30 µm or more, from the viewpoint of improving thermal conductivity, and may be 200 µm or less, 150 µm or less, 100 µm or less, or 80 µm or less, from the viewpoint of further improving insulating properties. In the present specification, the average particle diameter of the inorganic filler means a d50 diameter in a volume-based particle diameter distribution of the inorganic filler. The volume-based particle diameter distribution of the inorganic filler is measured by a laser diffraction particle diameter distribution measuring device.

The inorganic filler may contain two or more types of inorganic fillers having different average particle diameters. For example, the inorganic filler may contain a first inorganic filler having an average particle diameter of 25 µm or more and a second inorganic filler having an average particle diameter of 4 µm or less. According to such an inorganic fillers, since the second inorganic filler is filled in the gap between the first inorganic fillers, the filling density is increased, which contributes to improvement in thermal conductivity.

The average particle diameter of the first inorganic filler may be 30 µm or more or 40 µm or more, and may be 200 µm or less or 150 µm or less. The average particle diameter of the second inorganic filler may be 3.5 µm or less or 3 µm or less, and may be 0.05 µm or more or 0.1 µm or more.

From the viewpoint of improving thermal conductivity, the content of the inorganic filler may be 20% by volume or more, 30% by volume or more, 40% by volume or more, or 50% by volume or more, based on the total volume of the composition. The content of the inorganic filler may be 80% by volume or less, 70% by volume or less, or 60% by volume or less, based on the total volume of the composition from the viewpoint of further improving the insulation property, and may be preferably 55% by volume or less from the viewpoint of obtaining a metal-based substrate having more excellent insulation reliability against a high voltage under a high-temperature or high-temperature/high-humidity environment.

The copolymer contains a (meth)acrylic monomer unit A having an anionic group (hereinafter also referred to as "unit A" and a monomer giving the unit A is also referred to as "monomer A"), a (meth)acrylic monomer unit B having a cationic group (hereinafter also referred to as "unit B" and a monomer giving the unit B is also referred to as "monomer B"), and a (meth)acrylic monomer unit C other than the (meth)acrylic monomer unit A and the (meth)acrylic monomer unit B (hereinafter also referred to as "unit C" and a monomer giving the unit C is also referred to as "monomer C"). The copolymer may contain a (meth)acrylic monomer unit (unit X) having both an anionic group and a cationic group. In this case, it is defined that the unit X corresponds to the unit A and also corresponds to the unit B. In other words, the copolymer having the unit X is defined as having both the unit A and the unit B.

In the present specification, the "monomer" means a monomer having a polymerizable group before polymerization. The "monomer unit" means a structural unit derived from the monomer and constituting a copolymer. The "(meth)acrylic monomer" means a monomer having a (meth)acryloyl group. "(meth)acrylic monomer" means an acrylic monomer and a methacrylic monomer corresponding thereto, and similar expressions such as "(meth)acryloyl group" have the same meaning.

The copolymer has one type or two or more types of each of the unit A, the unit B, and the unit C. In one embodiment, the copolymer may contain only the unit A, the unit B, and the unit C. The copolymer may be a random copolymer or or may be a block copolymer. Each of the monomer A, the monomer B, and the monomer C may be a monomer having one (meth)acryloyl group (monofunctional (meth)acrylic monomer), may be a monomer having two or more (meth)acryloyl groups (polyfunctional (meth)acrylic monomer), and is preferably a monofunctional (meth)acrylic monomer.

The anionic group contained in the unit A is, for example, one or more selected from the group consisting of a carboxyl group, a phosphoric acid group, a phenolic hydroxy group, and a sulfonic acid group. From the viewpoint of further improving the dispersibility of the inorganic filler, the anionic group is preferably one or more selected from the group consisting of a carboxy group, a phosphoric acid group, and a phenolic hydroxy group.

From the viewpoint of further improving the dispersibility of the inorganic filler, the unit A preferably further has an electron withdrawing group bonded to an anionic group. The electron withdrawing group has a function of stabilizing the anion of the anionic group. Examples of the electron withdrawing group include a halogen group (also referred to as halogeno group). Examples of the anion group to which an electron withdrawing group is bonded include a group in which a halogen group is bonded to the carbon atom at the α-position of a carboxyl group.

The unit A may have no electron donating group bonded to an anionic group. The electron donating group may destabilize the anion of the anionic group. Examples of the electron donating group include a methyl group.

Examples of the monomer A include acrylic acid, methacrylic acid, acid phosphoxy propyl methacrylate, acid phosphoxy polyoxyethylene glycol monomethacrylate, acid phosphoxy polyoxypropylene glycol monomethacrylate, phosphoric acid-modified epoxy acrylates, 2-acryloyloxyethyl acid phosphate, 2-methacryloyloxyethyl acid phosphate, 4-hydroxyphenyl acrylate, 4-hydroxyphenyl methacrylate, 2-methacryloyloxyethylsuccinic acid and 2-acrylamido-2-methylpropanesulfonic acid. From the viewpoint of further improving the dispersibility of the inorganic filler, the monomer A is preferably one or more selected from the group consisting of acrylic acid, 2-methacryloyloxyethyl phosphate, 4-hydroxyphenyl methacrylate, and 2-acrylamido-2-methylpropanesulfonic acid, and more preferably acrylic acid.

The cationic group contained in the unit B is, for example, one or more selected from the group consisting of a primary amino group, a secondary amino group, a tertiary amino group, and a quaternary ammonium salt group. The cationic group is preferably a tertiary amino group from the viewpoint of further improving the dispersibility of the inorganic filler.

From the viewpoint of further improving the dispersibility of the inorganic filler, the unit B preferably further has an electron donating group bonded to a cationic group. The electron donating group has a function of stabilizing the cation of the cationic group. Examples of the electron donating group include a methyl group. Examples of the cation group to which an electron donating group is bonded include groups in which a methyl group is bonded to the carbon atom at the α-position of an amino group.

The unit B may have no electron withdrawing group bonded to the cationic group. The electron withdrawing group may destabilize the cation of the cationic group. Examples of the electron withdrawing group include a carboxy group.

Examples of the monomer B include 1-aminoethyl acrylate, 1-aminopropyl acrylate, 1-aminoethyl methacrylate, 1-aminopropyl methacrylate, dimethylaminoethyl methacrylate, diethylaminoethyl methacrylate, t-butylaminoethyl (meth)acrylate, dimethylaminoethyl methacrylate quaternary salts, 1,2,2,6,6-pentamethyl-4-piperidyl methacrylate, 2,2,6,6-tetramethyl-4-piperidyl methacrylate, and dimethyl aminoethyl acrylate benzylchlrolide quaternary salt. From the viewpoint of further improving the dispersibility of the inorganic filler, the monomer B is preferably one or more selected from the group consisting of 1,2,2,6,6-pentamethyl-4-piperidyl methacrylate and 2,2,6,6-tetramethyl-4-piperidyl methacrylate, and more preferably 1,2,2,6,6-pentamethyl-4-piperidyl methacrylate.

The monomer C is a (meth)acrylic monomer containing neither a cationic group nor an anionic group. In addition to the (meth)acryloyl group, a hydrophobic group, or a hydrophilic group in addition to the (meth)acryloyl group. That is, the unit C may have an amphiphilic group, a hydrophobic group, or a hydrophilic group. Examples of the amphiphilic group include an oxyalkylene group. Examples of the hydrophobic group include a siloxane group and a hydrocarbon group. Examples of the hydrophilic group include a phosphoric acid ester group. The hydrocarbon group referred to herein does not include a methyl group constituting a methacryloyl group (hereinafter, the same applies to the hydrocarbon group in the monomer C and the unit C).

When the composition further contains a resin, the unit C contains one or more selected from the group consisting of an oxyalkylene group, a siloxane group, and a hydrocarbon group, and more preferably contains one or more selected from the group consisting of a siloxane group and a hydrocarbon group, from the viewpoint of affinity or compatibility between the copolymer and the resin.

Examples of the (meth)acrylic monomer having an oxyalkylene group include ethoxycarbonylmethyl (meth)acrylate, phenol ethylene oxide-modified (meth)acrylate, phenol (ethylene oxide 2 mol-modified) (meth)acrylate, phenol (ethylene oxide 4 mol-modified) (meth)acrylate, p-cumylphenol ethylene oxide-modified (meth)acrylate, nonylphenol ethylene oxide-modified (meth)acrylate, nonylphenol (ethylene oxide 8 mol-modified) (meth)acrylate, nonylphenol (propylene oxide 2.5 mol-modified) acrylate, 2-ethylhexylcarbitol (meth)acrylate, ethylene oxide-modified phthalic acid (meth)acrylate, ethylene oxide-modified succinic acid (meth)acrylate, and tetrahydrofurfuryl (meth)acrylate.

Examples of the (meth)acrylic monomer having a siloxane group include α-butyl-ω-(3-methacryloxypropyl) polydimethylsiloxane. Examples of the (meth)acrylic monomer having a hydrocarbon group include methyl (meth)acrylate, ethyl (meth)acrylate, propyl (meth)acrylate, butyl (meth)acrylate, 2-ethylhexyl (meth)acrylate, isooctyl (meth)acrylate, isodecyl (meth)acrylate, lauryl (meth)acrylate, stearyl (meth)acrylate, phenyl (meth)acrylate, cyclohexyl (meth)acrylate, dicyclopentanyl (meth)acrylate, dicyclopentenyl (meth)acrylate, dicyclopentenyloxyethyl (meth)acrylate, isobornyl (meth)acrylate, and methoxylated cyclodecatriene (meth)acrylate.

Examples of the (meth)acrylic monomer having a phosphoric acid ester group include a (meth)acryloyloxyehtyl dialkyl phosphate.

In addition to the above, the monomer C may be, for example, a (meth)acrylic monomer having a hydroxy group. Examples of the (meth)acrylic monomer having a hydroxy group include 2-hydroxyethyl (meth)acrylate, 2-hydroxypropyl (meth)acrylate, 3-hydroxypropyl (meth)acrylate, 4-hydroxybutyl (meth)acrylate, 2-hydroxy-3-phenoxypropyl (meth)acrylate, and 3-chloro-2-hydroxypropyl (meth)acrylate.

The monomer C may be, for example, a (meth)acrylic monomer having an amide bond. Examples of the (meth)acrylic monomer having an amide bond include N,N-dimethyl (meth) acrylamide, N,N-diethyl (meth) acrylamide, N-isopropyl (meth) acrylamide, diacetone (meth) acrylamide, and acryloylmorpholine.

The monomer C may be, for example, a polyfunctional (meth)acrylic monomer. Examples of the polyfunctional (meth)acrylic monomer include 1,3-butylene glycol di(meth)acrylate, 1,4-butanediol di(meth)acrylate, 1,6-hexanediol di(meth)acrylate, 1,9-nonanediol di(meth)acrylate, neopentyl glycol di(meth)acrylate, dicyclopentanyl di(meth)acrylate, 2-ethyl-2-butyl-propanediol (meth)acrylate, neopentyl glycol-modified trimethylolpropane di(meth)acrylate, stearic acid-modified pentaerythritol di(meth)acrylate, 2-(1,2-cyclohexacarboximide) ethyl (meth)acrylate, hexanediol di(meth)acrylate, and polyfunctional (meth)acrylate having a bisphenol structure.

The content of the unit A may be 0.03% by mole or more, 0.1% by mole or more, 0.5% by mole or more, 1% by mole or more, 2% by mole or more, 3% by mole or more, 4% by mole or more, or 5% by mole or more, and may be 70% by mole or less, 60% by mole or less, 50% by mole or less, 40% by mole or less, 30% by mole or less, 20% by mole or less, or 15% by mole or less, based on 100% by mole of the total of the unit A, the unit B, and the unit C. The content of the unit A may be within the above range with respect to 100% by mole in total of all the monomer units contained in the copolymer. When the content of the unit A is 0.03% by mole or more, the dispersibility of the inorganic filler tends to be further improved. When the content of the unit A is 70% by mole or less, the viscosity of the composition tends to be further reduced, and the handleability of the composition tends to be further improved.

The content of the unit B may be 0.02% by mole or more, 0.05% by mole or more, 0.07% by mole or more, or 0.1% by mole or more, and may be 20% by mole or less, 10% by mole or less, 5% by mole or less, 3% by mole or less, or 1% by mole or less, based on 100% by mole of the total of the unit A, the unit B, and the unit C. The content of the unit B may be within the above range with respect to 100% by mole in total of all the monomer units contained in the copolymer. When the content of the unit B is 0.02% by mole or more, the affinity of the copolymer for the inorganic filler tends to be more favorable. When the content of the unit B is 20% by mole or less, there is a tendency that the viscosity of the composition is further decreased and the handling property of the composition is further improved.

The content of the unit C may be 10% by mole or more, 20% by mole or more, 30% by mole or more, 40% by mole or more, 50% by mole or more, 60% by mole or more, 70% by mole or more, 80% by mole or more, or 90% by mole or more, and may be 99.8% by mole or less, 99% by mole or less, 98% by mole or less, 97% by mole or less, or 96% by mole or less, based on 100% by mole of the total of the unit A, the unit B, and the unit C. The content of the unit C may be within the above range with respect to 100% by mole in total of all the monomer units contained in the copolymer. When the content of the unit C is 10% by mole or more, the viscosity of the composition tends to be further reduced, and the handleability of the composition tends to be further improved. When the content of the unit C is 99.8% by mole or less, the affinity of the copolymer for the inorganic filler tends to be more favorable.

The total content of the unit A and the unit B may be 0.05% by mole or more, 0.2% by mole or more, 1% by mole or more, 2% by mole or more, 3% by mole or more, 4% by mole or more, or 5% by mole or more, and 90% by mole or less, 80% by mole or less, 70% by mole or less, 60% by mole or less, 50% by mole or less, 40% by mole or less, 30% by mole or less, 20% by mole or less, or 10% by mole or less, based on 100% by mole of the total of the unit A, the unit B, and the unit C. The total content of the unit A and the unit B may be within the above range with respect to 100% by mole of the total of all monomer units contained in the copolymer. When the total content of the unit A and the unit B is 0.05% by mole or more, the dispersibility of the inorganic filler tends to be further improved. When the total content of the unit A and the unit B is 90% by mole or less, the handleability of the composition tends to be further improved.

The molar ratio of the unit A to the unit B (unit A / unit B) may be 0.01 or more, 0.9 or more, 1 or more, 5 or more, 10 or more, 20 or more, or 30 or more, and may be 200 or less, 150 or less, 100 or less, 90 or less, 80 or less, 70 or less, 60 or less, 50 or less, 40 or less, 30 or less, 20 or less, 15 or less, or 10 or less. When the molar ratio of the unit A to the unit B is within the above range, the dispersibility of the inorganic filler tends to be further improved.

The weight average molecular weight of the copolymer may be 1,000 or more, 5,000 or more, 7,000 or more, 10,000 or more, 20,000 or more, 30,000 or more, 40,000 or more, or 50,000 or more, and may be 1,000,000 or less, 500,000 or less, 300,000 or less, 100,000 or less, 90,000 or less, 80,000 or less, 70,000 or less, or 60,000 or less. When the weight average molecular weight of the copolymer is 1,000 or more, the dispersibility of the inorganic filler can be maintained and an increase in the hardness of the composition can be suppressed even when the composition is stored for a long time in a high-temperature environment. In addition, the shape retention of the composition is improved, and when the composition is applied to an inclined surface or a vertical surface, displacement or dripping of the composition is suppressed. When the weight average molecular weight of the copolymer is 1,000,000 or less, there is a tendency that the viscosity of the composition is further reduced and the handling property of the composition is further improved. The weight average molecular weight of the copolymer is determined as a weight average molecular weight in terms of standard polystyrene by using a gel permeation chromatography (GPC) method.

The content of the copolymer is 0.1 to 10 parts by mass with respect to 100 parts by mass of the inorganic filler. When the content of the copolymer is within this range, when an insulating layer of a metal-based substrate is formed using the composition, a metal-based substrate having excellent insulation reliability against a high voltage under a high-temperature or high-temperature/high-humidity environment can be obtained.

The lower limit of the content of the copolymer may be preferably 0.5 parts by mass or more or 1 part by mass or more, more preferably 2 parts by mass or more, 2.5 parts by mass or more, 3 parts by mass or more, 4 parts by mass or more, or 5 parts by mass or more, with respect to 100 parts by mass of the inorganic filler, from the viewpoint of obtaining a metal-based substrate further excellent in insulation reliability against a high voltage under a high-temperature or high-temperature/high-humidity environment. The upper limit of the content of the copolymer may be preferably 9.5 parts by mass or less or 9 parts by mass or less, more preferably 8 parts by mass or less, 7.5 parts by mass or less, 7 parts by mass or less, 6 parts by mass or less, or 5 parts by mass or less, with respect to 100 parts by mass of the inorganic filler, from the viewpoint of obtaining a metal-based substrate further excellent in insulation reliability against high voltage under a high-temperature or high-temperature/high-humidity environment.

The composition may further contain a resin. The resin referred to herein is different from the above-described copolymer. The resin is preferably a thermosetting resin. Examples of the thermosetting resin include a silicone resin, an epoxy resin, a phenol resin, a cyanate resin, a melamine resin, an urea resin, a thermosetting polyimide resin, and an unsaturated polyester resin. The resin is preferably an epoxy resin. The resin may be used alone or in combination of two or more.

From the viewpoint of further improving the insulating properties, the content of the resin may be 20% by volume or more, 30% by volume or more, or 40% by volume or more based on the total volume of the composition. From the viewpoint of improving thermal conductivity, the content of the resin may be 80% by volume or less, 70% by volume or less, 60% by volume or less, or 50% by volume or less, based on the total volume of the composition.

When the composition contains the resin, the composition may further contain a curing agent for curing the resin. The curing agent is appropriately selected according to the type of the resin. For example, when the resin is an epoxy resin, examples of the curing agent include an amine-based resin, an acid anhydride-based resin, and a phenol-based resin. The curing agent may be used alone or in combination of two or more.

The content of the curing agent may be 1% by volume or more and 10% by volume or less based on the total volume of the composition.

The composition may further contain additinoal components. Examples of the additional components include a curing accelerator, a coupling agent, a leveling agent, an antioxidant, an antifoaming agent, a wetting agent, and a stabilizer.

The composition is obtained by mixing the inorganic filler and the copolymer (and the resin, the curing agent, and the additional components used as necessary). The mixing may be performed using, for example, a planetary stirrer, a universal mixing stirrer, a kneader, a hybrid mixer, or the like.

The above-described copolymer is obtained by polymerizing the monomer A, the monomer B, and the monomer C by a known polymerization method. Examples of the polymerization method include radical polymerization and anionic polymerization. The polymerization method is preferably radical polymerization.

The polymerization initiator used in the radical polymerization may be a thermal polymerization initiator or a photopolymerization initiator. Examples of the thermal polymerization initiator include azo compounds such as azobisisobutyronitrile, and organic peroxides such as benzoyl peroxide, tert-butyl hydroperoxide, and di-tert-butyl peroxide. Examples of the photopolymerization initiator include a benzoin derivative. The polymerization initiator may be a known polymerization initiator used for living radical polymerization such as ATRP or RAFT.

The polymerization conditions can be appropriately adjusted according to the type of the monomer, the polymerization initiator, and the like. When the copolymer is a random copolymer, each monomer may be mixed in advance and polymerized. When the copolymer is a block copolymer, each monomer may be sequentially added to the polymerization system.

The above-described composition is used in a cured form, particularly when the composition contains the resin and the curing agent. That is, one embodiment of the present invention is a cured product of the composition described above. The cured product may be in a semi-cured state (B stage) or in a completely cured state (C stage).

The cured product is obtained by, for example, curing the above-described composition by heat treatment. Conditions of the heat treatment (heating temperature, heating time, and the like) are appropriately set according to the types of the resin and the curing agent, a desired curing state, and the like. The heat treatment may be performed in one step or in two steps.

The cured product may be in the form of a sheet, for example. The sheet-shaped cured product is obtained by, for example, applying the above-described composition onto a base material and heating (and pressurizing as necessary) the composition. The sheet-shaped cured product may be a B stage sheet in a semi-cured state or a C stage sheet in a completely cured state.

The above-described composition and cured product are suitably used for forming an insulating layer of a metal-based substrate. That is, the composition and the cured product can also be referred to as a metal-based substrate composition and a metal-based substrate cured product, respectively.

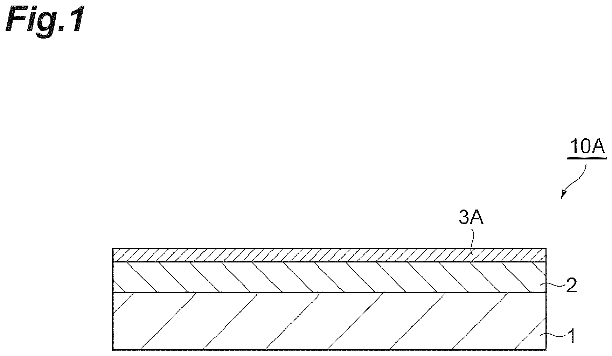

FIG. 1 is a schematic cross-sectional view showing an embodiment of a metal-based substrate. As shown in FIG. 1, the metal-based substrate 10A according to one embodiment contains a metal plate 1, a cured product (cured product of the composition described above) 2 disposed on the metal plate, and a metal foil 3A disposed on the cured product 2. In the metal-based substrate 10A, the metal plate 1 and the metal foil 3A are isolated from each other by the cured product 2, and are kept electrically insulated from each other. That is, the cured product 2 functions as an insulating layer.

Examples of the metal material constituting the metal plate 1 include aluminum, an aluminum alloy, copper, a copper alloy, iron, and a stainless steel. The metal plate 1 may be made of one type of metal material or two or more types of metal materials. The metal plate 1 may have a single layer structure or a multilayer structure.

Examples of the metal material constituting the metal foil 3A include cupper, aluminum, and nickel. The metal foil 3A may be made of one type of metal material or two or more types of metal materials. The metal foil 3A may have a single layer structure or a multilayer structure.

The thickness of the metal plate 1, for example, may be 0.5 mm or more and may be 3 mm or less. The thickness of the cured product 2, for example, may be b50 µm or more and may be 300 µm or less. The metal foil 3A, for example, may be 5 µm or more, and may be 1 mm or less.

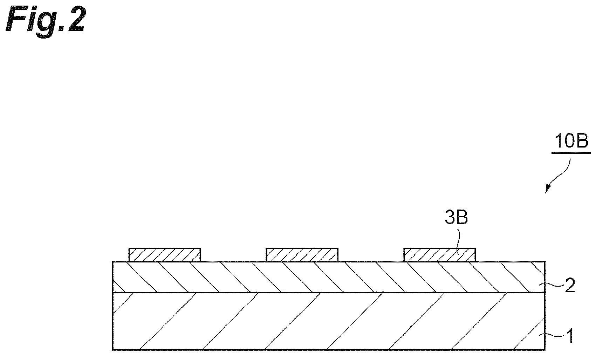

In the above-described embodiment, the metal foil 3A is disposed on substantially the entire surface of the cured product 2, but in another embodiment, the metal foil may be disposed on only a part of the cured product 2. FIG. 2 is a schematic cross-sectional view showing another embodiment of the metal-based substrate. As shown in FIG. 2, the metal-based substrate 10B according to another embodiment contains a metal plate 1, a cured product (cured product of the composition described above) 2 disposed on the metal plate, and a metal foil 3B disposed on the cured product 2.

In the metal-based substrate 10B, the metal foil 3B is processed (for example, etched) into, for example, a predetermined pattern to form a circuit. That is, it can be said that the metal-based substrate 10B contains the metal plate 1, the cured product 2 disposed on the metal plate, and the metal circuit disposed on the cured product 2.

### Examples

Hereinafter, the present invention will be described in more detail with reference to examples, but the present invention is not limited to these examples.

### <Synthesis of copolymer>

Monomers used for synthesis of the copolymer are shown below.
((Meth)acrylic monomer A having anionic group)
Acrylic acid (manufactured by Toagosei Co., Ltd.)
((Meth)acrylic monomer B having cationic group)
1,2,2,6,6-pentamethyl-4-piperidyl methacrylate (manufactured by ADEKA Corporation, "ADK STAB LA-82")
((Meth)acrylic monomer C)
Benzyl methacrylate (manufactured by Kyoeisha Chemical Co., Ltd., "Light Ester BZ")

First, 100 parts by mass of a (meth)acrylic monomer having a monomer composition (% by mole) shown in Table 1 was added to an autoclave equipped with a stirrer. Subsequently, 0.5 parts by mass of azobisisobutyronitrile (manufactured by Tokyo Chemical Industry Co., Ltd.) as a polymerization initiator and 1000 parts by mass of a mixed solution of toluene (reagent special grade) and 2-propanol (reagent special grade) (toluene : 2-propanol = 7 : 3 (volume ratio)) as a solvent were added to 100 parts by mass of the total of the (meth)acrylic monomers, and the autoclave was purged with nitrogen. Thereafter, the autoclave was heated in an oil bath at 65°C for 20 hours to perform radical polymerization. After completion of the polymerization, degassing was performed under reduced pressure at 120°C for 1 hour to obtain copolymers 1 to 5.

The polymerization rate with respect to 100% of the charged amount of the monomer was analyzed by gas chromatography and found to be 98% or more. From this, the ratio of each monomer unit contained in the copolymer was estimated to be approximately the same as the charging ratio of the monomers.

In addition, the weight average molecular weights of the obtained copolymers 1 to 5 were determined as weight average molecular weights in terms of standard polystyrene using a gel permeation chromatography (GPC) method. The results are shown in Table 1. The measurement conditions are as follows.
High-speed GPC apparatus: "HLC-8020" manufactured by Tosoh Corporation
Columns: one column of "TSK guardcolumn MP (×L)" manufactured by Tosoh Corporation 6.0 mm ID × 4.0 cm, and two columns of "TSK-GELMULTIPOREHXL M" manufactured by Tosoh Corporation 7.8 mm ID × 30.0 cm (theoretical plate number: 16,000), three columns in total (theoretical plate number: 32,000 as a whole)
Developing solvent: tetrahydrofuran
Detector: RI (differential refractometer)

**[Table 1]**

| Copolymer No. | | | 1 | 2 | 3 | 4 | 5 |
|---|---|---|---|---|---|---|---|
| Formulation of monomers (% by mole) | Monomer A | Acrylic acid | 5 | 15 | 2 | 0.1 | 0.1 |
| | Monomer B | 1,2,2,6,6-pentamethyl-4-piperidyl methacrylate | 0.1 | 0.1 | 0.5 | 0.1 | 5 |
| | Monomer C | Benzyl methacrylate | 94.9 | 84.9 | 97.5 | 99.8 | 94.9 |
| Weight average molecular weight of copolymer | | | 58,000 | 65,000 | 51,000 | 48,000 | 49,000 |

### <Preparation of composition>

### (Example 1)

42.3% by volume of naphthalene type epoxy resin HP-4032D (manufactured by DIC Corporation, specific gravity 1.2 g/cm³) as a resin and 5.7% by volume of phenol novolac resin VH-4150 (manufactured by DIC Corporation, specific gravity 1.1 g/cm³) as a curing agent were stirred at 170°C to dissolve the curing agent in the resin. The resins in which the curing agent was dissolved, 50.5% by volume of boron nitride filler (manufactured by Denka Co., Ltd., FP-40, average particle diameter: 40 µm) as inorganic filler (1), 1.0% by volume of the copolymer 1, and 0.4% by volume of an imidazole compound 1B2PZ (manufactured by Shikoku Chemicals Corporation, specific gravity 1.1 g/cm³) as a curing accelerator were stirred and mixed for 15 minutes by a planetary mixer to prepare a composition.

### <Preparation of cured product>

The obtained composition was applied onto a polyethylene terephtalate film having 0.038 mm thickness such that the thickness after curing was 0.20 mm, and dried by heating at 100°C for 50 minutes to produce a semi-cured cured product (B stage sheet).

### <Production of metal-based substrate>

The obtained cured product (B stage sheet) was peeled off from the PET film and placed on the roughened surface of a metal plate (copper plate having a 2.0 mm thickness). Then, a roughened surface of a metal foil (copper foil having a 0.5 mm thickness) was placed on the cured product, and they were heated at 180°C for 410 minutes while applying a surface pressure 10 MPa by a press machine and the semi-cured product was cured.

Next, after a predetermined position was masked with an etching resist, the copper foil was etched using a sulfuric acid-hydrogen peroxide mixed solution as an etching solution. The etching resist was removed, and the substrate was washed and dried to obtain a metal-based substrate having a circular electrode (copper foil) having a 20 mm diameter.

### (Examples 2 to 13 and Comparative Examples 1 to 2)

Composition, cured products, and metal-based substrates were produced in the same manner as in Example 1 except that the formulations of the compositions were changed as shown in Tables 2 and 3. In Tables 2 and 3, the inorganic filler (2) and the inorganic filler (3) are as follows.
Inorganic filler (2)
   Alumina filler (manufactured by Denka Co., Ltd., DAS-45, average particle diameter: 40 µm)
Inorganic filler (3)
   Aluminum nitride filler (manufactured by Denka Co., Ltd., AlN-32, average particle diameter: 32 µm)

### [Evaluation of insulation reliability in high-temperature environment]

The obtained metal-based substrates were subjected to a high-temperature/high-pressure bias test (V-t) under test conditions in which a voltage of a direct current 10 kV was applied between the metal foil and the metal plate in an environment of 125°C. The time from the start of voltage application to the time when the leakage current value measured by a voltage resistance tester became equal to or greater than 10 mA was defined as the endurance time. A case where the durability time was 200 minutes or more was evaluated as "A", a case where the durability time was less than 200 minutes and 100 minutes or more was evaluated as "B", and a case where the durability time was less than 100 minutes was evaluated as "C". When the evaluation is "A" or "B", it can be said that the metal-based substrate has excellent insulation reliability under a high-temperature environment. The results are shown in Tables 2 and 3.

### [Evaluation of insulation reliability in high-temperature/high-humidity environment]

The obtained metal-based substrates were subjected to a high-temperature/high-pressure bias test (THB) under test conditions in which a voltage of 1.2 kV of direct current was applied between the metal foil and the metal plate in an environment of 85°C and 85% RH. The time from the start of voltage application to the time when the leakage current value measured by a voltage resistance tester became equal to or greater than 10 mA was defined as the endurance time. A case where the durability time was 250 hours or more was evaluated as "A", a case where the durability time was less than 250 hours and 100 hours or more was evaluated as "B", and a case where the durability time was less than 100 hours was evaluated as "C". When the evaluation is "A" or "B", it can be said that the metal-based substrate has excellent insulation reliability under the high-temperature/high-humidity environment. The results are shown in Tables 2 and 3.

**[Table 2]**

| | | Example 1 | Example 2 | Example 3 | Example 4 | Example 5 | Comp. Example 1 | Comp. Example 2 |
|---|---|---|---|---|---|---|---|---|
| Inorganic filler No. | | (1) | (1) | (1) | (1) | (1) | (1) | (1) |
| Copolymer No. | | 1 | 1 | 1 | 1 | 1 | - | 1 |
| Formulation of composition (% by volume) | Inorganic filler | 50.5 | 50.5 | 50.5 | 50.5 | 50.5 | 50.5 | 50.5 |
| | Copolymer | 1 | 3 | 5 | 7 | 9 | - | 12 |
| | Resin | 42.3 | 40.7 | 38.9 | 37.2 | 35.4 | 43.2 | 32.8 |
| | Curing agent | 5.7 | 5.5 | 5.3 | 5 | 4.8 | 5.8 | 4.4 |
| | Curing accelerator | 0.4 | 0.4 | 0.3 | 0.3 | 0.3 | 0.4 | 0.3 |
| Content of copolymer with respect to 100 parts by mass of inorganic filler (parts by mass) | | 1 | 3 | 5 | 7 | 9 | - | 12 |
| Evaluation results | Insulation reliability in high-temperature environment | B | A | A | A | B | C | C |
| | Insulation reliability in high-temperature / high-humidity environment | B | A | A | A | B | C | C |

**[Table 3]**

| | | Example 6 | Example 7 | Example 8 | Example 9 | Example 10 | Example 11 | Example 12 | Example 13 |
|---|---|---|---|---|---|---|---|---|---|
| Inorganic filler No. | | (1) | (1) | (1) | (1) | (1) | (1) | (2) | (3) |
| Copolymer No. | | 1 | 3 | 4 | 5 | 1 | 1 | 1 | 1 |
| Formulation of composition (% by volume) | Inorganic filler | 50.5 | 50.5 | 50.5 | 50.5 | 40.0 | 60.0 | 50.5 | 50.5 |
| | Copolymer | 5 | 5 | 5 | 5 | 4.0 | 5.9 | 5 | 5 |
| | Resin | 38.9 | 38.9 | 38.9 | 38.9 | 49.0 | 29.8 | 38.9 | 38.9 |
| | Curing agent | 5.3 | 5.3 | 5.3 | 5.3 | 6.6 | 4.0 | 5.3 | 5.3 |
| | Curing accelerator | 0.3 | 0.3 | 0.3 | 0.3 | 0.4 | 0.3 | 0.3 | 0.3 |
| Content of copolymer with respect to 100 parts by mass of inorganic filler (parts by mass) | | 5 | 5 | 5 | 5 | 5 | 5 | 5 | 5 |
| Evaluation results | Insulation reliability in high-temperature environment | A | A | A | A | A | B | A | A |
| | Insulation reliability in high-temperature / high-humidity environment | A | A | A | A | A | B | A | A |

### Reference Signs List

1: metal plate, 2: cured product, 3A, 3B: metal foil, 10A, 10B: metal-based substrate.

## Claims

1. A composition comprising:
an inorganic filler; and
a copolymer comprising a (meth)acrylic monomer unit A having an anionic group, a (meth)acrylic monomer unit B having a cationic group, and a (meth)acrylic monomer unit C other than the (meth)acrylic monomer unit A and the (meth)acrylic monomer unit B,
wherein a content of the copolymer is 0.01 to 10 parts by mass with respect to 100 parts by mass of the inorganic filler.

2. The composition according to claim 1, wherein the anionic group comprises one or more selected from the group consisting of a carboxy group, a phosphoric acid group, and a phenolic hydroxy group.

3. The composition according to claim 1 or 2, wherein the (meth)acrylic monomer unit A further has an electron withdrawing group bonded to the anionic group.

4. The composition according to any one of claims 1 to 3, wherein the cationic group comprises one or more selected from the group consisting of a primary amino group, a secondary amino group, a tertiary amino group, and a quaternary ammonium salt group.

5. The composition according to any one of claims 1 to 4, wherein the (meth)acrylic monomer unit B further has an electron donating group bonded to the cationic group.

6. The composition according to any one of claims 1 to 5, wherein the (meth)acrylic monomer unit C comprises one or more selected from the group consisting of an oxyalkylene group, a siloxane group, a hydrocarbon group, and a phosphoric acid ester group.

7. The composition according to any one of claims 1 to 6, further comprising a resin.

8. The composition according to claim 7, further comprising a curing agent for curing the resin.

9. A cured product of the composition according to claim 8.

10. A metal-based substrate comprising:
a metal plate;
the cured product according to claim 9 disposed on the metal plate; and
a metal foil disposed on the cured product.
